# EUROPEAN PATENT APPLICATION

(11) **EP 2 450 714 A2**
(43) Date of publication of application: **09.05.2012**
(21) Application number: 11187853.4
(22) Date of filing: 04.11.2011
(51) Int. Cl.: G01R 13/02

(54) **Test and measurement instrument with oscillator phase dejitter**

(30) Priority: 04.11.2010 US 939777
(71) Applicant: Tektronix, Inc., Beaverton, Oregon 97077-0001 (US)
(72) Inventor: Pickerd, John J., Hillsboro, OR Oregon 97123 (US)
(74) Representative: Brinck, David John Borchardt

(57) **Abstract**

A test and measurement instrument including an oscillator configured to generate a periodic signal; a mixer configured to mix an input signal with the periodic signal to generate a frequency-shifted signal; a trigger system configured to generate a trigger signal; a phase detector configured to sense a phase between the trigger signal and the periodic signal; and a controller configured to adjust processing of the frequency-shifted signal in response to the phase.

## Description

### BACKGROUND

This invention relates to test and measurement instruments and, more particularly, to test and measurement instruments with oscillator phase dejitter.

Digital oscilloscopes have limited input bandwidths. Digitizers, amplifiers, and other components have limited bandwidths. Thus, a maximum input frequency of a sampled signal can be limited. To increase the effective bandwidth, an input signal can be split into multiple split signals. One split signal is digitized. Simultaneously, the other split signals are frequency shifted to a baseband frequency range that is within a digitizing bandwidth of the acquisition circuitry. A split signal can be frequency shifted by mixing the split signal with a periodic signal generated by an oscillator. The frequency shifted split signals can then be digitized. However, a phase shift relative to a trigger can be introduced by the respective periodic signals.

The digitized frequency-shifted signals are frequency shifted to their original frequency range and then combined with the other digitized signals to create a representation of the input signal. The phase shifts introduced by the periodic signals can distort the reconstructed signal.

### BRIEF DESCRIPTION OF THE DRAWINGS

FIGURE 1 is a block diagram of a test and measurement instrument with an all pass filter according to an embodiment of the invention.

FIGURE 2 is a graph illustrating a phase shift between a trigger signal and a periodic signal.

FIGURE 3 is a block diagram of frequency shifting circuit of a test and measurement instrument according to an embodiment of the invention.

FIGURE 4 is a block diagram of another frequency shifting circuit of a test and measurement instrument according to an embodiment of the invention.

FIGURE 5 is a block diagram of acquisition circuitry of a test and measurement instrument according to an embodiment of the invention.

### DETAILED DESCRIPTION

This disclosure describes embodiments of a test and measurement instrument using mixing with signal processing to reduce distortion during bandwidth multiplication. For example, as described above, a phase shift can be introduced into a digitized version of a frequency shifted input signal sub-band. This phase shift is a phase shift relative to a trigger signal. Each sub-band of the input signal within a split signal that is frequency shifted can have a different phase shift introduced relative to each other and the baseband sub-band. When recombined, the sub-bands will have the phase shift. As will be described in further detail below, the phase shift can be compensated.

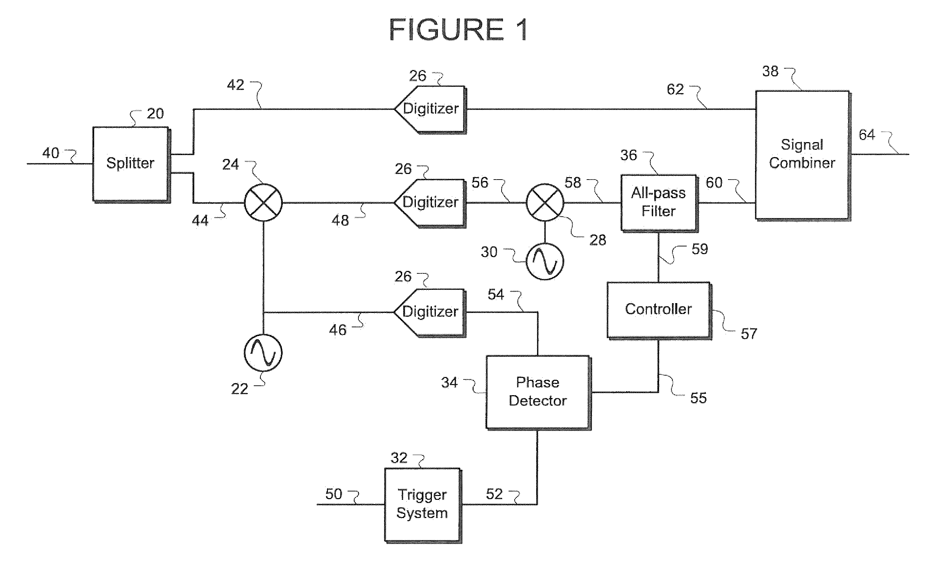

FIGURE 1 is a block diagram of a test and measurement instrument with an all pass filter according to an embodiment of the invention. The test and measurement instrument includes a splitter 20. The splitter 20 is configured to split an input signal 40 into a plurality of split signals represented here by split signals 42 and 44. The splitter 20 can be a variety of splitters. In one example, the splitter 20 is a resistive power divider.

In an embodiment, the splitter 20 is configured to split the input signal 40 into split signals 42 and 44 such that the spectrums of the split signals 42 and 44 are substantially identical. Substantially identical includes variations caused by component variations. For example, a splitter 20 may be designed to produce identical split signals 42 and 44; however, each split signal can be slightly different. Such split signals 42 and 44 are still considered substantially identical.

In another embodiment, the splitter 20 is configured to split the input signal 21 into split signals 42 and 44 having unequal spectrums. As will be described below, various frequency components of each split signal contribute to the reconstructed signal. However, for proper reconstruction, all of the frequency components can, but need not pass through each path. Thus, in one embodiment each split signal 42 and 44 needs only the frequency components of the input signal 40 that will be used from that split signal in the reconstructed signal. Accordingly, the splitter 20 can split the input signal 40 such that the split signals 42 and 44 have the desired spectrums.

Although two split signals 42 and 44 have been described, the input signal 40 can be split into any number of split signals. For example, the splitter 20 can be configured to split the input signal 40 into four split signals, each associated with a different frequency sub-band. The two split signals 42 and 44 are used here merely as an example.

The test and measurement instrument includes digitizers 26. Although not illustrated, each digitizer 26 can have a preamplifier, attenuators, filters, and/or other analog circuitry in the analog channel as needed. Thus, the input signals to the digitizers 26 can be amplified, attenuated, or otherwise filtered before digitization. In addition, the digitizers 26 can be any variety of circuitry that can digitize a signal. For example, the digitizers 26 can include circuitry such as track and hold circuits, A/D converters, de-multiplexer circuits as needed to sample the associated input signals.

In one path, the split signal 42 can be digitized by digitizer 26 to generate the digitized split signal 62. As this split signal 42 can be a baseband signal, i.e. it was not frequency shifted, the digitized split signal 62 can represent the baseband component used by the signal combiner 38 to recombine the signals into the reconstructed signal 64.

In another path, the split signal 44 is input to a mixer 24. An oscillator 22 is configured to generate a periodic signal 46 input to the mixer 24. The combination of the periodic signal 46 and the split signal 44 can generate the frequency shifted signal 48. The frequency shifted signal 48 can be digitized by digitizer 26.

In an embodiment, the digitizers 26 can be configured to sample the respective input signals at substantially the same time. However, due to the frequency shifting of the mixer 24 a phase shift is introduced into the frequency shifted signal 48. In particular, the periodic signal 46 generated by the oscillator 22 can be asynchronous with a trigger input 50 used to trigger an acquisition. As the periodic signal 46 may not be synchronized with the trigger signal 50, the relative phase of the periodic signal 46 to the trigger input 50 can change from trigger event to trigger event.

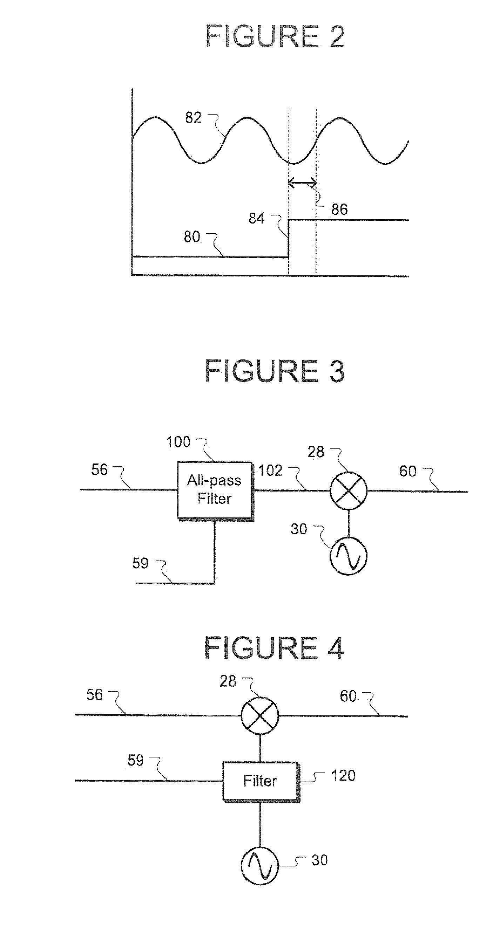

FIGURE 2 is a graph illustrating a phase shift between a trigger signal and a periodic signal. A trigger signal 80 is illustrated with a trigger event 84. As will be described in further detail below, the trigger signal 80 can be a signal generated from a trigger input 50 as illustrated in FIGURE 1. A periodic signal 82 is illustrated relative to the trigger signal 80. A reference point on the periodic signal 86 is offset from the trigger signal 80 by time 86. Although a particular time is illustrated, since the trigger signal 80 is not synchronous with the periodic signal 82, the time 86 can change for each different trigger event 84. Accordingly, the phase shift introduced into each split signal associated with the periodic signal 82 will be changing between triggered acquisitions.

Referring back to FIGURE 1, when digitized by digitizer 26, the frequency shifted signal 48 results in a digitized frequency shifted signal 56. The phase shift introduced by the periodic signal 46 is present in the digitized frequency shifted signal 56. However, appropriate processing of the digitized frequency shifted signal 56 can substantially remove the phase shift.

For example, in this embodiment, the digitized frequency shifted signal 56 is mixed with a periodic signal represented by oscillator 30. As the signals here are digitized, the mixing can be performed by multiplication of the digitized signals in an appropriate processor. For example, a digital signal processor (DSP), microprocessor, programmable logic device, or other processing system with appropriate peripheral devices can implement the functionality of the above described and other components, such as the controller 57, the phase detector 34, the all pass filter 36, the signal combiner 38, or the like. In other examples, each block can be implemented discretely. Any variation between complete integration to fully discrete components can be implemented.

The mixer 28 can output a restored split signal 58 where the digitized frequency shifted signal 56 is substantially restored to its original frequency range as in split signal 44. In this example, the restored split signal 58 has the phase shift described above. However, the restored split signal 58 can be filtered by all pass filter 36. The all pass filter can have a phase response that is the opposite of the phase shift induced by the periodic signal 46. Thus, when the output compensated split signal 60 is input to the signal combiner 38, the phase difference between the compensated split signal 60 and the digitized split signal 62 can be substantially eliminated.

Although an all pass filter 36 has been described, the phase correction can be implemented in other ways. For example, other filtering can be performed on the restored split signal 58 such as band pass filtering, spectral shaping filtering, or the like. The phase adjustment of the all pass filter 36 can be part of such other filtering. In another example, the all pass filter 36 can be part of the signal combiner 38. As will be described in further detail below, the phase correction can be implemented in other ways than filtering the restored split signal 58.

The test and measurement instrument can include a trigger system 32. The trigger system 32 can be configured to generate a trigger signal 52 in response to a trigger input 50. As described above, phase shifts relative to the trigger signal 52 can be different for every acquisition period. The trigger signal 52 can be compared with the digitized periodic signal 54 to generate a phase signal 55 in the phase detector 34. For example any circuit that can measure a time or phase difference can be used as the phase detector 34. In another embodiment, the phase detector 34 can be implemented as part of the controller 57 and/or other processing circuitry.

In another embodiment, the phase detector 34 can be similar to circuits that measure the time from the trigger to the sample clock. In contrast, in this application it is the time from the trigger to a reference point of the periodic signal, such as a rising zero crossing, that is measured. In one example, such circuits use constant current sources charging a capacitor in order to measure the required time interval. Other circuits could be devised to perform similar measurements to measure the time or phase.

In an embodiment, time and phase can be used as desired. For example, the periodic signal 46 can be a substantially single frequency. Thus, a given time corresponds to a given phase. The phase detector 34 can be configured to measure a time between the trigger signal and the periodic signal and convert the time to the phase. Accordingly, the phase signal 55 and/or other representations of the difference in phase of the trigger signal 52 and the periodic signal 50 can be represented as time or phase.

The controller 57 can be configured to adjust processing of the digitized frequency-shifted signal 56 in response to the phase signal 55. In this example, the controller 57 is configured to adjust the all pass filter 36 in response to the phase signal 55 using a control signal 59. For example, the adjustment to the all pass filter 36 can be a recalculation of the filter equation.

In another example, a set of multiple filters can be calculated in advance. The controller can be configured to select a filter in response to the phase. For example, the controller can convert the phase 55 into an index into the set of filters. The index can be the control signal 59 used to select a filter for the all pass filter 36. Thus, the all pass filter 36 need not be recalculated each acquisition.

FIGURE 3 is a block diagram of frequency shifting circuit of a test and measurement instrument according to an embodiment of the invention. The phase correction of a split signal can be accomplished in a variety of ways. In FIGURE 1, the digitized frequency shifted signal 56 was restored to its substantially original frequency range by the mixer 28 and oscillator 30. The restored split signal 58 was then filtered to correct the phase.

However, as illustrated in FIGURE 3, the processing of the digitized frequency shifted signal 56 can be different. In particular, an all pass filter 100 can be configured to filter the digitized frequency shifted signal 56 to generate a filtered frequency shifted signal 102. That is, the phase error can be corrected in the path followed by the particular split signal before the signal is restored to its original frequency range. Similar to the all pass filter 36 described above, the all pass filter 100 can be a part of other filtering, can be responsive to a control signal 59 from a controller 57, can be an index of precalculated filters, or the like.

FIGURE 4 is a block diagram of another frequency shifting circuit of a test and measurement instrument according to an embodiment of the invention. In this embodiment, the digitized frequency shifted signal 56 need not be filtered by an all pass filter as described above. In contrast, the phase correction can be introduced into the periodic signal mixed with the digitized frequency shifted signal 56 in the mixer 28.

For example, a filter 120 can be used to filter the periodic signal from the mixer 30. Although the filter 120 can be an all pass filter, in this embodiment, the filter can be a more narrow filter with an amplitude response that not 1 at all frequencies. That is, since the periodic signal occupies a substantially narrow frequency range, a similarly narrow filter can be used. By phase shifting the periodic signal from the mixer 30, a compensating phase shift can be introduced into the digitized frequency shifted signal 56 when restored to its substantially original frequency range.

Although a filter has been described in a technique to shift the phase of a periodic signal from the oscillator 30, other techniques can be used. For example, the generation of the periodic signal itself in the oscillator 30 can be adjusted so that the relative phase has the desired phase offset. That is, in an embodiment, the oscillator 30 can be a digital oscillator generated by a function. A phase offset can be introduced into that function from acquisition to acquisition.

Accordingly, the phase correction can be implemented in a variety of ways. In an embodiment, the phase correction can be adjusted from acquisition to acquisition. Thus, even though a trigger input 50 can be asynchronous with an oscillator 22 resulting in the phase offset between the two varying from acquisition to acquisition, the varying phase offset can be compensated, reducing jitter in the reconstructed signal 64.

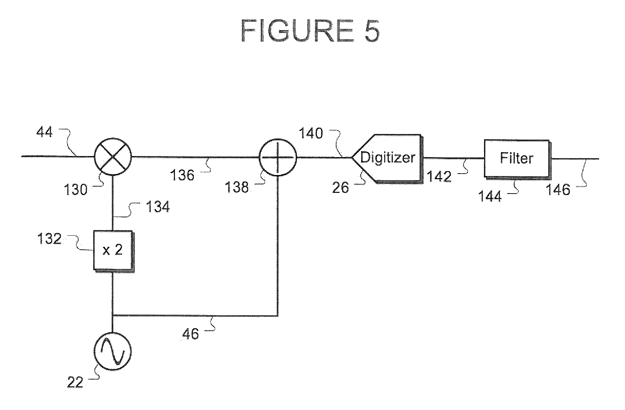

FIGURE 5 is a block diagram of acquisition circuitry of a test and measurement instrument according to an embodiment of the invention. In FIGURE 1, the periodic signal 46 from the oscillator 22 was digitized and supplied to the phase detector 34. As illustrated in FIGURE 5, the phase information of the periodic signal 46 can be obtained in different ways.

In an embodiment, the split signal 44 is mixed with a periodic signal 134 in mixer 130. However, the periodic signal 132 can be generated by a frequency doubler 132. That is, the frequency of the periodic signal 46 is doubled to generate the periodic signal 134. In an embodiment, the frequency of the doubled periodic signal 134 can be on a high frequency side of a desired sub-band in the split signal 44.

A combiner 138 can combine the frequency shifted split signal 136 with the periodic signal 46. The combined signal 140 can then be digitized by digitizer 26. The resulting digitized frequency shifted split signal 142 can be used for multiple purposes. For example, the desired sub-band is present in the digitized frequency shifted split signal 142 and can be used accordingly.

In addition, a signal that is synchronized with the periodic signal 134 used to frequency shift the split signal 44 is also present. Accordingly, the digitized frequency shifted split signal 142 can be filtered by a filter configured to substantially isolate the periodic signal 146 from the digitized frequency-shifted split signal 142. This substantially isolated signal can then be used in the phase detector 34 as described above.

Although digitizing the periodic signal 46 and passing the periodic signal 46 through a channel have been describe above, any other technique that can pass phase information about the periodic signal 46 into the instrument can be used by the controller 57 to adjust the processing of split signals.

Another embodiment includes computer readable code embodied on a computer readable medium that when executed, causes the machine to perform any of the above-described operations. As used here, a computer is any device that can execute code. Microprocessors, programmable logic devices, multiprocessor systems, digital signal processors, personal computers, or the like are all examples of such a machine. In an embodiment, the computer readable medium can be a tangible computer readable medium that is configured to store the computer readable code in a non-transitory manner.

An example of a test and measurement instrument is an oscilloscope platform. Other examples of a digitizing platform include a spectrum analyzer, a logic analyzer, or the like. Any instrument with a goal of converting an analog waveform into a digital waveform represented by binary samples stored in memory can be implemented with an embodiment described herein.

Although particular embodiments have been described, it will be appreciated that the principles of the invention are not limited to those embodiments. Variations and modifications may be made without departing from the principles of the invention as set forth in the following claims.

## Claims

1. A test and measurement instrument, comprising:
an oscillator configured to generate a periodic signal;
a mixer configured to mix an input signal with the periodic signal to generate a frequency-shifted signal;
a trigger system configured to generate a trigger signal;
a phase detector configured to sense a phase between the trigger signal and the periodic signal; and
a controller configured to adjust processing of the frequency-shifted signal in response to the phase.

2. The test and measurement instrument of claim 1, further comprising:
a first digitizer configured to digitize the input signal; and
a second digitizer configured to digitize the frequency-shifted signal;
wherein the controller is configured to adjust processing of the digitized frequency-shifted signal before combination with the digitized input signal.

3. The test and measurement instrument of claim 1, further comprising:
a digitizer configured to digitize the periodic signal;
wherein the phase detector is responsive to the digitized periodic signal.

4. The test and measurement instrument of claim 1, further comprising:
a digitizer configured to digitize the frequency-shifted signal; and
a filter configured to substantially isolate the periodic signal from the digitized frequency-shifted signal;
wherein the phase detector is responsive to the substantially isolated periodic signal.

5. The test and measurement instrument of claim 1, wherein the phase detector is configured to:
measure a time between the trigger signal and the periodic signal; and
convert the time to the phase.

6. The test and measurement instrument of claim 1, wherein the controller is configured to:
select a filter in response to the phase; and
filter the frequency-shifted signal in response to the selected filter.

7. The test and measurement instrument of claim 1, further comprising:
a digitizer configured to digitize the frequency-shifted signal;
wherein the controller is configured to filter the digitized frequency-shifted signal in response to the phase.

8. The test and measurement instrument of claim 1, further comprising:
a digitizer configured to digitize the frequency-shifted signal;
wherein the controller is configured to:
frequency shift the digitized frequency-shifted signal to a substantially original frequency range to generate a digitized sub-band signal; and
filter the digitized sub-band signal in response to the phase.

9. The test and measurement instrument of claim 1, further comprising:
a digitizer configured to digitize the frequency-shifted signal;
wherein the controller is configured to:
frequency shift the digitized frequency-shifted signal to a substantially original frequency range to generate a digitized sub-band signal in response to a second periodic signal; and
filter the second periodic signal in response to the phase.

10. The test and measurement instrument of claim 1, wherein the controller is configured to adjust processing of the frequency-shifted signal in response to the phase for each acquisition triggered by the trigger system.

11. A method, comprising:
mixing an input signal with a periodic signal to generate a frequency-shifted signal;
generating a trigger signal;
sensing a phase between the trigger signal and the periodic signal; and
adjusting processing of the frequency-shifted signal in response to the phase.

12. The method of claim 11, further comprising:
digitizing the input signal; and
digitizing the frequency-shifted signal; and
adjusting processing of the digitized frequency-shifted signal before combination with the digitized input signal.

13. The method of claim 11, further comprising:
digitizing the frequency-shifted signal;
filtering the digitized frequency-shifted signal to substantially isolate the periodic signal from the digitized frequency-shifted signal; and
sensing the phase between the trigger signal and the substantially isolated periodic signal.

14. The method of claim 11, further comprising:
selecting a filter in response to the phase; and
filtering the frequency-shifted signal in response to the selected filter.

15. The method of claim 11, further comprising:
digitizing the frequency-shifted signal;
frequency shifting the digitized frequency-shifted signal to a substantially original frequency range to generate a digitized sub-band signal; and
filtering the digitized sub-band signal in response to the phase.
